(19) Europäisches Patentamt / European Patent Office / Office européen des brevets

(11) **EP 3 258 682 B1**

(12) **FASCICULE DE BREVET EUROPEEN**

(45) Date de publication et mention
de la délivrance du brevet:
**20.02.2019  Bulletin 2019/08**

(51) Int Cl.:
*H03M 1/12* *(2006.01)*    *H04N 5/335* *(2011.01)*
*H03M 1/08* *(2006.01)*

(21) Numéro de dépôt: **17175752.9**

(22) Date de dépôt: **13.06.2017**

(54) **CHAINE D'ACQUISITION D'UN SIGNAL ANALOGIQUE**

ANALOGE SIGNALVERARBEITUNSKETTE

ACQUISITION CHAIN FOR ANALOG SIGNAL

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **13.06.2016  FR 1655437**

(43) Date de publication de la demande:
**20.12.2017  Bulletin 2017/51**

(73) Titulaire: **AERIEL**
**26120 Montelier (FR)**

(72) Inventeur: **RIBET, Jean-Luc**
**26120 MONTELIER (FR)**

(74) Mandataire: **Brevalex**
**95, rue d'Amsterdam**
**75378 Paris Cedex 8 (FR)**

(56) Documents cités:
**EP-A2- 0 677 922      JP-A- H03 295 362**
**JP-A- 2006 060 512    US-A- 6 111 606**
**US-A1- 2009 201 373   US-A1- 2015 279 882**

## Description

### DOMAINE TECHNIQUE

La présente invention concerne le domaine des chaînes d'acquisition de signaux analogiques en vue de leur conversion en signaux numériques. Plus particulièrement, l'invention concerne un dispositif adapté pour atténuer le bruit d'un signal analogique avant sa conversion en un signal numérique par un convertisseur analogique numérique.

### ÉTAT DE LA TECHNIQUE ANTÉRIEURE

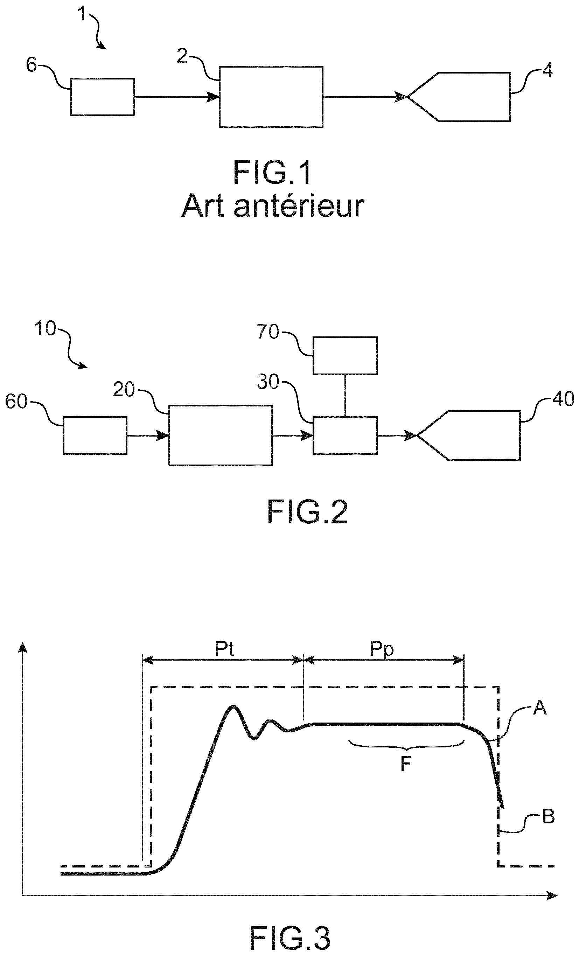

Une chaine d'acquisition 1 connue de l'homme du métier et illustrée à la figure 1 est généralement constituée de :

-   un capteur 6 adapté pour exécuter une mesure d'au moins une grandeur physique et la traduire en au moins un signal analogique ;
-   un module de traitement 2 adaptée pour traiter le signal analogique transmis par le capteur 6, par exemple l'amplifier, le filtrer et/ou encore l'échantillonner ETC ;
-   un convertisseur 4 analogique numérique adapté pour convertir le signal analogique, traité par le module de traitement, en un signal numérique.

Le capteur 6 peut être tout dispositif capable de transformer une grandeur physique en une grandeur électrique qui constituera l'au moins un signal analogique.

Parmi les grandeurs physiques, nous pouvons citer par exemple la température, le nombre de photons (par exemple dans un capteur d'images tel qu'un capteur CCD, un capteur CMOS, des photodiodes etc.), et la grandeur électrique peut prendre, indépendamment, la forme d'un courant et/ou d'une tension.

Le traitement peut comprendre une étape d'échantillonnage lorsque nous sommes en présence d'un capteur multicanaux. En effet, un capteur d'image, par exemple, peut délivrer plusieurs signaux analogiques. Ainsi, un traitement séquentiel des différents signaux analogiques est imposé par la chaîne d'acquisition selon un ordre établi par une horloge. Un tel traitement est par exemple exécuté par un multiplexeur.

Le traitement peut également comprendre une amplification du signal analogique transmis à la chaîne d'acquisition 2 par le capteur 6.

Enfin, la chaine d'acquisition 1 peut exécuter un pré filtrage des signaux électriques issus du capteur.

Cependant, ce dispositif n'est pas optimal, notamment le signal analogique est empreint d'un bruit, induit par le capteur et/ou la chaîne d'acquisition. La présence du bruit dans le signal analogique nuit à la fidélité du signal de sortie par rapport à la grandeur physique en entrée du capteur.

Par ailleurs, dès lors que l'au moins un signal est converti en au moins un signal numérique par le convertisseur 4 analogique numérique, l'atténuation du bruit ne peut qu'être réalisée par le filtrage numérique sur plusieurs échantillons d'un signal analogique stable.

Le document US 6111606 décrit un dispositif de traitement du signal présentant une architecture simplifiée.

Le document JP 2006060512 décrit un capteur d'images.

Un but de la présente invention est alors de proposer un dispositif d'atténuation du bruit d'un signal analogique avant sa conversion en un signal numérique.

### EXPOSÉ DE L'INVENTION

Le but précédemment énoncé est atteint par une chaine d'acquisition d'au moins un signal analogique, la chaine d'acquisition comprenant :

-   un module de traitement d'au moins un signal analogique présentant dans l'ordre une partie transitoire et un palier, l'au moins un signal analogique étant destiné à être transmis, par ledit module de traitement, à un convertisseur analogique/numérique adapté pour transformer l'au moins un signal analogique en au moins un signal numérique ;
-   un module de commutation de fréquence de coupure présentant une fréquence de coupure fc, le module étant adapté pour commuter la valeur de sa fréquence de coupure fc entre une première fréquence fc1 et une seconde fréquence fc2, la première fréquence fc1 étant supérieure à la seconde fréquence fc2, le module de commutation de fréquence de coupure comprenant une entrée connectée à une sortie du module de traitement, la commutation de la fréquence de coupure fc de la première fréquence de coupure fc1 à la seconde fréquence de coupure intervenant dès lors que le palier du signal analogique est atteint,

le module de traitement comprend en outre une seconde sortie en opposition de phase avec la première, formant ainsi deux signaux appelés signaux différentiels, la seconde sortie étant connectée un second module de commutation de fréquence de coupure présentant une fréquence de coupure fc, le module étant adapté pour commuter la valeur de sa fréquence de coupure fc entre la première fréquence fc1 et la seconde fréquence fc2, le module de commutation de fréquence et le second module de commutation de fréquence étant adaptés pour transmettre chacun en leur sortie respective des signaux analogiques en opposition de phase, les signaux analogiques en sortie des modules de commutation étant destinés à être traités par le convertisseur.

Selon un mode de mise en oeuvre, la chaine d'acquisition comprend une entrée connectée avec une sortie d'un capteur, ledit capteur étant destiné à transmettre l'au moins un signal analogique correspondant à au moins une grandeur physique mesurée par le capteur.

Avantageusement, le capteur comprend au moins un des éléments choisis parmi : un capteur d'image CCD, un capteur d'image CMOS, une photodiode, un capteur de température, un capteur de pression, un capteur d'ondes sonores.

Selon un mode de mise en oeuvre, la chaine d'acquisition comprend un contrôleur de commutation adapté pour commander la commutation de la valeur de la fréquence de coupure du module commutation de fréquence de coupure entre la première fréquence fc1 et la seconde fréquence fc2.

Selon un mode de mise en oeuvre, la chaine d'acquisition comprend un convertisseur analogique/numérique.

Selon un mode de mise en oeuvre, le module de commutation de fréquence de coupure est agencé de manière à ce que le convertisseur analogique/numérique soit connecté au module de traitement via ledit module de commutation de fréquence de coupure.

Selon un mode de mise en oeuvre, le module de commutation de fréquence de coupure comprend un condensateur C dont une borne est connectée à la masse de la chaîne d'acquisition et l'autre borne est connectée à une sortie dudit module de commutation, le module de commutation comprend également une première résistance électrique R1 et une seconde résistance électrique R2, les résistances électriques R1 et R2 étant connectées selon deux branches parallèles entre l'entrée et la sortie du module de commutation, le module de commutation comprenant également un interrupteur I adapté pour ouvrir et fermer la branche comprenant la résistance électrique R1.

Selon un mode de mise en oeuvre, le contrôleur de commutation commande l'interrupteur I pour la commutation de la valeur de la fréquence de coupure du module commutation de fréquence de coupure entre la première fréquence fc1 et la seconde fréquence fc2.

Selon un mode de mise en oeuvre, l'interrupteur I est un transistor ou un commutateur électronique analogique.

Selon un mode de mise en oeuvre, le second module de commutation de fréquence de coupure est agencé de manière à ce que le convertisseur analogique/numérique soit connecté à la chaine d'acquisition également via ledit second module de commutation de fréquence de coupure.

L'invention concerne également un procédé d'atténuation du bruit d'un signal analogique avant sa conversion en un signal numérique, le procédé comprenant :

a. une étape de traitement d'au moins un signal analogique par une chaine d'acquisition, l'au moins un signal analogique présentant une forme d'onde impulsionnelle, la forme d'onde impulsionnelle comprenant, en séquence, une partie transitoire et un palier, la chaine d'acquisition se comportant comme un filtre passe-bas et présentant une fréquence de coupure,

b. une étape de transmission de l'au moins un signal analogique à un convertisseur analogique numérique par la chaine d'acquisition, le procédé exécute une commutation de la fréquence de coupure entre une première fréquence et une seconde fréquence inférieure à la première fréquence, de sorte que la fréquence de coupure de la chaine d'acquisition soit égale à la première fréquence pendant au moins toute l'étendue de la partie transitoire, et soit égale à la seconde fréquence sur l'étendue restante de la forme impulsionnelle, l'étendue restante étant non nulle.

Selon un mode de mise en oeuvre, le procédé comprend la transmission de l'au moins un signal analogique à la chaine d'acquisition par un capteur, le capteur comprenant une sortie connectée à une entre de la chaine d'acquisition, l'au moins un signal analogique correspondant à au moins une grandeur physique mesurée par le capteur.

Avantageusement, le capteur comprend au moins un des éléments choisis parmi : un capteur d'image CCD, un capteur d'image CMOS, une photodiode, un capteur de température, un capteur de pression, un capteur d'ondes sonores.

Selon un mode de mise en oeuvre, le procédé comprend la commande de commutation de la valeur de la fréquence de coupure du module commutation de fréquence de coupure, entre la première fréquence fc1 et la seconde fréquence fc2, par un contrôleur de commutation compris dans la chaine d'acquisition.

Selon un mode de mise en oeuvre, la chaine d'acquisition est connectée à un convertisseur analogique/numérique.

Selon un mode de mise en oeuvre, le module de commutation de fréquence de coupure est agencé de manière à ce que le convertisseur analogique/numérique soit connecté à la chaine d'acquisition via ledit module de commutation de fréquence de coupure.

Selon un mode de mise en oeuvre, le module de commutation de fréquence de coupure comprend un condensateur C dont une borne est connectée à la masse de la chaîne d'acquisition et l'autre borne est connectée à une sortie dudit module de commutation, le module de commutation comprend également une première résistance électrique R1 et une seconde résistance électrique R2, les résistances électriques R1 et R2 étant connectées selon deux branches parallèles entre l'entrée et la sortie du module de commutation, le module de commutation comprenant également un interrupteur I adapté pour ouvrir et fermer la branche comprenant la résistance électrique R1.

Selon un mode de mise en oeuvre, le contrôleur de commutation commande l'interrupteur I pour la commutation de la valeur de la fréquence de coupure du module commutation de fréquence de coupure entre la première fréquence fc1 et la seconde fréquence fc2.

Selon un mode de mise en oeuvre, l'interrupteur I est un transistor ou un commutateur électronique analogique.

Selon un mode de mise en oeuvre, le module de traitement comprend une seconde sortie différentielle, la seconde sortie différentielle étant connectée à un second module de commutation de fréquence de coupure présentant une fréquence de coupure fc, le module étant adapté pour commuter la valeur de sa fréquence de coupure fc entre une première fréquence fc1 et une seconde fréquence fc2, la première fréquence fc1 étant supérieure à la seconde fréquence fc2, le module de commutation de fréquence et le second module de commutation de fréquence étant adaptés pour transmettre chacun en leur sortie respective des signaux analogiques en opposition de phase .

Selon un mode de mise en oeuvre, le second module de commutation de fréquence de coupure est agencé de manière à ce que le convertisseur analogique/numérique soit connecté à la chaine d'acquisition également via ledit second module de commutation de fréquence de coupure.

## BRÈVE DESCRIPTION DES DESSINS

D'autres caractéristiques et avantages apparaîtrons dans la description qui va suivre des modes de réalisation de la chaine d'acquisition selon l'invention, donnés à titre d'exemples non limitatifs, en référence aux dessins annexés dans lesquels :

- la figure 1 est un schéma synoptique simplifié d'une chaine d'acquisition connectée à un convertisseur analogique/numérique selon l'art antérieur,
- la figure 2 est un schéma synoptique simplifié d'une chaine d'acquisition selon un premier mode de réalisation de l'invention,
- la figure 3 représente une forme d'onde impulsionnelle réelle (courbe A) du signal analogique en comparaison avec une fonction créneau (courbe B), l'axe vertical représente l'amplitude du signal analogique, et l'axe horizontal représente Ir temps (nous notons que les courbes A et B ne sont pas mis à l'échelle selon l'axe vertical),
- la figure 4 représente l'influence de la valeur de la fréquence de coupure sur l'amortissement de la partie transitoire,
- la figure 5 représente un exemple de mise en oeuvre du module de commutation selon l'invention,
- la figure 6 est un schéma synoptique simplifié d'une chaine d'acquisition selon un second mode de réalisation de l'invention.

## EXPOSÉ DÉTAILLÉ DE MODES DE RÉALISATION PARTICULIERS

L'invention décrite de manière détaillée ci-dessous met en oeuvre l'insertion, dans une chaine d'acquisition 10, d'un module de commutation 30 présentant une fréquence de coupure capable de commuter entre une première fréquence fc1 et une seconde fréquence fc2 inférieure à la première fréquence fc1. Il apparaîtra dans la description que le module de commutation 30 de fréquence de coupure se comporte comme un filtre. Tout au long de la description, et par souci de simplification de la description, le filtre sera considéré comme un filtre passe-bas, et la fréquence de coupure sera en fait une fréquence de coupure haute. Un filtre passe-bas est un filtre qui laisse passer les basses fréquences et qui atténue les hautes fréquences, c'est-à-dire les fréquences supérieures à la fréquence de coupure fc. Cependant, l'invention ne se limite pas à un filtre passe-bas, et peut se transposer sans difficultés à un filtre passe-bande, dans ces conditions, l'invention est relative à la commutation de la fréquence de coupure haute du filtre passe-bande. Par ailleurs, il apparaîtra clairement dans la description détaillée de l'invention qu'un tel module de commutation 30 de fréquence de coupure permet d'atténuer le bruit d'un signal analogique avant que ce dernier soit converti en un signal numérique. Dans tout l'exposé, par fréquence de coupure, nous entendons fréquence de coupure pour une atténuation à -3dB (d'autres atténuations restent cependant envisageables).

Pour les différents modes de mise en oeuvre, les mêmes références seront utilisées pour des éléments identiques ou assurant la même fonction, par souci de simplification de la description.

Sur la figure 2, on peut voir un exemple de chaine d'acquisition 10 selon l'invention.

La chaine d'acquisition 10 comprend un module de traitement 20 d'au moins un signal analogique. L'au moins un signal analogique est destiné à être transmis, par ledit module de traitement 20, à un convertisseur 40 analogique/numérique adapté pour transformer l'au moins un signal analogique en au moins un signal numérique.

Par traiter le traiter le signal analogique, nous entendons au moins une des fonctions choisie parmi : transmettre, amplifier, filtrer, échantillonner, ajouter une tension continue etc.

Le module de traitement 20 peut donc comprendre au moins un des éléments compris parmi : un amplificateur, un filtre, un échantillonneur, un câble de transmission etc.

Les différents agencements et/ou structures du module de traitement 20 sont connus de l'homme du métier et ne seront pas décrits dans l'exposé détaillé de l'invention.

Le traitement du signal analogique par le module de traitement 20 est exécuté avant la transmission dudit signal analogique à un convertisseur 40 analogique/numérique (CAN, selon la terminologie Anglo-Saxonne « ADC » pour « Analog to Digital Converter »). Un convertisseur 40 analogique/numérique est un montage électronique dont la fonction est de traduire un signal analogique en une valeur numérique (codée sur plusieurs bits).

La chaine d'acquisition 10 peut comprendre au moins une entrée connectée avec une sortie d'un capteur 60. Le capteur 60 est destiné à transmettre l'au moins un signal analogique correspondant à au moins une grandeur physique mesurée par le capteur 60.

Le capteur 60 est défini comme un dispositif mesurant une grandeur physique (en entrée du capteur 60) et transformant ladite grandeur physique en une grandeur électrique (en sortie du capteur 60). La grandeur électrique peut être une tension ou une intensité de courant (ci-après dénommé « courant »). La grandeur électrique est donc caractéristique de la grandeur physique mesurée par le capteur 60. La grandeur électrique est également nommée signal analogique.

La grandeur physique mesurée par le capteur 60 peut être une température, un nombre de photon, une pression, une variation de pression etc.

Dans ces conditions, le capteur 60 peut comprendre au moins un des éléments choisis parmi : un capteur d'image CCD (dispositif à transfert de charge ou « Charge Coupled Device » selon la terminologie Anglo-Saxonne), un capteur d'image CMOS (« *complementary metal-oxide-semiconductor* » selon la terminologie Anglo-Saxonne), une photodiode, un capteur de température, un capteur de pression, un capteur d'ondes sonores etc.

Le signal analogique, correspondant à l'au moins une grandeur physique mesurée par le capteur 60 et transmis au module de traitement 20, a une forme d'onde impulsionnelle. En sortie du module de traitement 20, le signal analogique conserve une forme d'onde impulsionnelle.

Dans un cas idéal, la forme d'onde pourrait être une fonction créneau, mais la réalité est toute autre. La figure 3 représente une forme d'onde impulsionnelle réelle - parmi d'autres possibles - (courbe A) du signal analogique en comparaison avec une fonction créneau (courbe B). L'axe vertical représente l'amplitude du signal analogique, et l'axe horizontal représente le temps.

La forme d'onde impulsionnelle s'étend sur une période temporelle finie et dénommée ci-après période impulsionnelle T. La période impulsionnelle T peut être contrôlée par une horloge qui sera décrite dans la suite de la description. La forme d'onde impulsionnelle du signal analogique comprend, en séquence, une partie transitoire (section Pt de la courbe A) et un palier (section Pp de la courbe A). La partie transitoire s'étend sur une période temporelle dite « période transitoire Tpt », et le palier s'étend sur une période temporelle dite « période palier Tpp ». Pour une chaine d'acquisition 10 donnée, la limite entre la partie transitoire et le palier est fixée en fonction de la période impulsionnelle et la fréquence de coupure de la chaine du capteur 60 et/ou du module de traitement 20. La période transitoire peut, par exemple en première approximation, être définie comme proportionnelle à l'inverse de la fréquence de coupure du module de traitement ou du capteur. La période impulsionnelle T est un paramètre considéré fixe pour le système dans lequel est insérée la chaîne d'acquisition.

Sur la figure 3, on peut observer une déviation de la partie transitoire par rapport au créneau formé par la courbe B. La partie transitoire est due à la modification de la grandeur physique en entrée du capteur 60. La forme de la partie transitoire dépend, généralement, des fonctions de transfert du capteur 60 et du module de traitement 20. Nous entendons par fonction de transfert un modèle mathématique de la relation entre l'entrée et la sortie d'un système linéaire.

La valeur du palier du signal analogique est représentative de la valeur de la grandeur physique mesurée. La période impulsionnelle est la somme de la période transitoire et de la période de palier.

La conversion du signal analogique en un signal numérique est généralement exécutée dès lors que le signal analogique a atteint le palier. Plus particulièrement, seule la section finale (section F illustrée à la figure 3) du palier du signal analogique est considérée pour sa conversion en un signal numérique car la pente du signal analogique, exprimée par sa dérivée par rapport au temps, y est la plus faible.

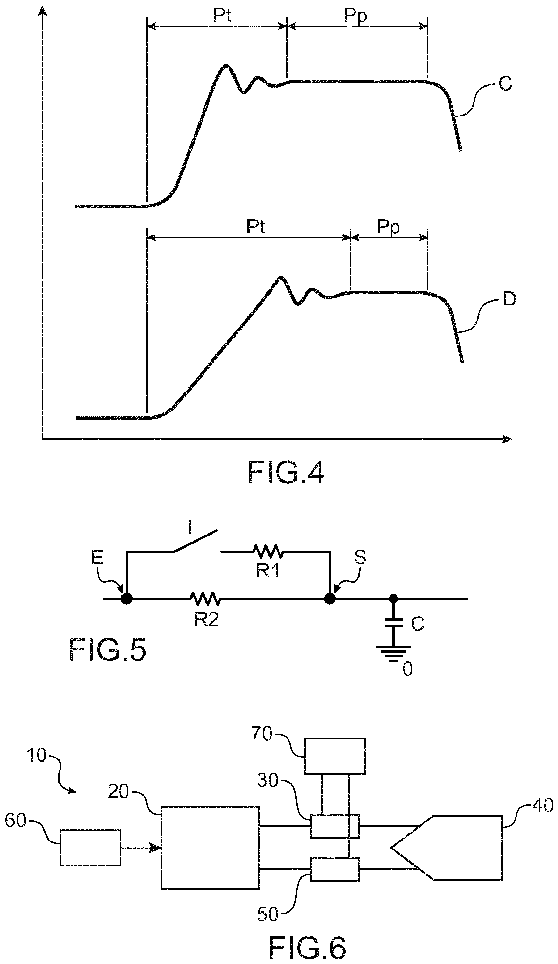

En général, le module de traitement 20 se comporte comme un filtre passe-bas comprenant une fréquence de coupure haute fc. Dans la pratique, la période transitoire doit être la plus courte possible pour que le palier puisse s'établir le plus rapidement possible. Ainsi, la fréquence de coupure du module de traitement 20 est donc généralement suffisamment élevée pour ne pas trop amortir la partie transitoire. Par amortir la partie transitoire nous entendons prolonger sa période temporelle. En effet, la durée (la période transitoire Tpt) de la partie transitoire traduit un amortissement qui est fonction notamment de la fréquence de coupure du module de traitement 20 et du capteur 60. Ainsi, plus la fréquence de coupure fc est faible plus la partie transitoire présente une période élevée. Ainsi la figure 4 illustre l'influence de l'amplitude de la fréquence de coupure sur l'amortissement de la partie transitoire. Les courbes C et D représentent chacune une partie transitoire obtenue pour une fréquence de coupure fcc et une fréquence de coupure fcd respectivement. La fréquence de coupure fcc est, dans le cas illustré à la figure 4, supérieure à la fréquence de coupure fcd. Ainsi, dans le cas de la courbe D, le palier arrive plus tard que dans le cas de la courbe C.

Un bruit électrique d'origine thermique peut généralement être observé sur le signal analogique, et plus particulièrement sur le palier. Lors de sa conversion en un signal numérique ledit bruit électrique est toujours présent et il peut être avantageux de le réduire avant l'étape de conversion analogique numérique. A cet égard, la Demanderesse propose de modifier la fréquence de coupure de la chaine d'acquisition 10 dès lors que le palier est atteint. De manière particulièrement avantageuse, la fréquence de coupure de la chaine d'acquisition 10 est commutée d'une première fréquence fc1 à une seconde fréquence fc2 inférieure à ladite première fréquence fc1.

Ainsi, selon l'invention, la chaine d'acquisition 10 comprend également un module de commutation 30 de fréquence de coupure présentant une fréquence de coupure fc. Le module est adapté pour commuter la valeur de sa fréquence de coupure fc entre une première fréquence fc1 et une seconde fréquence fc2, la première fréquence fc1 étant supérieure à la seconde fréquence fc2. Par ailleurs, le module de commutation 30 de fréquence de coupure comprend une entrée connectée à une sortie du module de traitement 20. Autrement dit le module de traitement 20 et le module de commutation 30 de sortie sont connectés en série.

Ainsi, il est possible avec la chaine d'acquisition 10 selon la présente invention de commuter la fréquence de coupure du module de commutation 30 entre la première fréquence fc1 et la seconde fréquence fc2. Plus particulièrement, il est possible d'exécuter une commutation de la fréquence de coupure entre une première fréquence fc1 et une seconde fréquence fc2 inférieure à la première fréquence fc1, de sorte que la fréquence de coupure du module de commutation 30 soit égale à la première fréquence fc1 pendant au moins toute l'étendue de la partie transitoire Pt de la forme impulsionnelle, et soit égale à la seconde fréquence fc2 sur l'étendue restante Pp de la forme impulsionnelle, l'étendue restante étant non nulle.

Ainsi, la Demanderesse a remarqué que dès lors que la partie transitoire Pt est terminée, la commutation de la fréquence de coupure du module de commutation 30 d'une première fréquence fc1 à une seconde fréquence fc2 inférieure à la première fréquence fc1 permet de réduire sensiblement le bruit du signal analogique. Plus particulièrement, la tension efficace du bruit sera réduite d'un facteur : $\sqrt{\dfrac{f_{c1}}{f_{c2}}}$.

La fréquence fc1 peut, avantageusement, être supérieure à la fréquence de coupure de l'ensemble comprenant le capteur 60 et le module de traitement 20.

Ainsi, dès lors que la fréquence de coupure du module de commutation 30 est égale à la première fréquence fc1 lors du déroulement de la partie transitoire Pt, ladite partie transitoire Pt est peu affectée lors de son passage dans ledit module de commutation 30. Autrement dit, la forme de la partie transitoire ne change pas lors du passage du signal analogique dans le module de commutation 30.

Par ailleurs, dès lors que la fréquence de coupure du module de commutation 30 est égale à la seconde fréquence fc2 lors du déroulement de l'étendue restante Er, toutes les composantes fréquentielles du signal analogique de fréquence f supérieure à fc2 sont filtrées. Autrement dit, lesdites composantes de fréquence f supérieure à fc2 sont bloquées par le module de commutation 30.

Nous entendons par composantes fréquentielle du signal analogique, les différentes composantes de Fourier du signal. Cette notion est parfaitement connue de l'homme du métier, et par conséquent, nous ne décrirons pas en détail le processus de décomposition en fréquences d'un signal.

Il est remarquable que le palier Pp est relativement stable, et que par conséquent peu ou pas de composantes dites « hautes fréquences » sont attendues. Cependant, le signal analogique est empreint d'un bruit, induit par le capteur 60 et/ou la chaîne d'acquisition. Le bruit est généralement caractérisé par des composantes de Fourier de « haute fréquence », plus particulièrement des fréquences supérieures à la seconde fréquence fc2.

Ainsi, la commutation de la fréquence de la première fréquence fc1 à la seconde fréquence fc2 du module de commutation 30 permet de filtrer, donc de bloquer, toute la partie du signal de fréquence supérieure à fc2. Autrement dit, le module de commutation 30 permet de filtrer le bruit.

De manière particulièrement avantageuse, la chaine d'acquisition 10 comprend un contrôleur de commutation 70 adapté pour commander la commutation de la valeur de la fréquence de coupure du module commutation de fréquence de coupure entre la première fréquence fc1 et la seconde fréquence fc2.

Le contrôleur de commutation 70 peut être un dispositif électronique synchronisé par ou avec la période impulsionnelle.

Le contrôleur de commutation 70 peut, par exemple, être un ordinateur, un calculateur, une carte de programmation, un module appelé séquenceur.

Toujours de manière avantageuse, le module de commutation 30 de fréquence de coupure est agencé de manière à ce que le convertisseur 40 analogique/numérique soit connecté à la chaine d'acquisition 10 via ledit module de commutation 30 de fréquence de coupure. Autrement dit, le module de commutation 30 est disposé le plus en aval possible de la chaine d'acquisition 10. Ainsi, le module de commutation 30 peut filtrer le bruit, et plus particulièrement le bruit thermique, généré dans tous les éléments et/ou modules impliqués dans le traitement du signal analogique.

La figure 5 donne à titre d'exemple, un module de commutation 30 de fréquence de coupure selon l'invention. Ainsi, dans l'exemple illustré à la figure 5, le module de commutation 30 de fréquence de coupure comprend un condensateur C comprenant une borne connectée à la masse de la chaîne d'acquisition, et l'autre borne connectée à une sortie dudit module de commutation 30. Le module de commutation 30 comprend également une première résistance électrique R1 et une seconde résistance électrique R2, les résistances électriques R1 et R2 étant connectées selon deux branches parallèles entre l'entrée E et la sortie S du module de commutation 30, le module de commutation 30 comprenant également un interrupteur I adapté pour ouvrir et fermer la branche comprenant la résistance électrique R1. Dans cet exemple, la commutation de la fréquence de coupure du module de commutation 30 est générée par l'ouverture ou la fermeture de l'interrupteur I.

Ainsi, lorsque l'interrupteur est ouvert, la fréquence de coupure du module de commutation 30 est égale à fc2 :

$$fc2 = \frac{1}{2\pi R_2 C}$$

lorsque l'interrupteur est fermé, la fréquence de coupure du module de commutation 30 est égale à fc1 :

$$fc1 = \frac{R_1 + R_2}{2\pi R_1 R_2 C}$$

De manière avantageuse, le contrôleur de commutation 70 commande l'interrupteur I pour la commutation de la valeur de la fréquence de coupure du module commutation de fréquence de coupure entre la première fréquence fc1 et la seconde fréquence fc2. Avantageusement, l'interrupteur I peut être un transistor ou un commutateur électronique analogique. Ainsi, le temps de commutation est rapide par rapport à la dynamique de traitement du signal analogique par la chaine d'acquisition 10. Toujours de manière avantageuse, la résistance électrique R1 et l'interrupteur I peuvent être confondus et comprendre un transistor ou un commutateur électronique analogique.

L'invention ne se limite cependant pas au type de module de commutation 30 décrit ci-haut, et tout autre module ou dispositif adapté pour commuter sa fréquence de coupure peut être mise en oeuvre dans le cadre de la présente invention.

Il faut cependant noter que la commutation de la fréquence de coupure du système de commutation peut générer des perturbations sur le signal analogique. Ainsi, pour résoudre ce problème, le module de traitement 20 peut comprendre une seconde sortie (illustré à la figure 6). Nous entendons par seconde sortie, une sortie pour laquelle le signal analogique est en opposition de phase par rapport à la sortie du module de traitement 20, formant ainsi deux signaux appelés signaux différentiels. La seconde sortie est connectée à un second module de commutation 50 de fréquence de coupure présentant une fréquence de coupure fc. Le second module étant adapté pour commuter la valeur de sa fréquence de coupure fc entre la première fréquence fc1 et la seconde fréquence fc2. Le module de commutation 30 de fréquence et le second module de commutation 50 de fréquence sont adaptés pour transmettre chacun en leur sortie respective des signaux analogiques en opposition de phase.

Par ailleurs, le second module de commutation 50 de fréquence de coupure est agencé de manière à ce que le convertisseur 40 analogique/numérique soit connecté à la chaine d'acquisition 10 également via ledit second module de commutation 50 de fréquence de coupure.

Dans les faits, il peut être nécessaire pour la chaine d'acquisition de traiter une pluralité de signaux analogiques. Pour ce faire, chaque signal analogique de la pluralité de signaux analogiques est transmis selon une séquence prédéfinie par une horloge (que l'on nomme horloge d'échantillonnage) au module de traitement 20. L'horloge d'échantillonnage est par exemple un multiplexeur comportant une pluralité de voies de transmission. Chaque voie de la pluralité de voies de transmission étant connectée à un site photosensible d'un capteur d'image par exemple. Le contrôleur de commutation 70 est de préférence synchronisé avec l'horloge d'échantillonnage du multiplexeur, et commande au module de commutation 30, et éventuellement au second module de commutation 50 s'il est également considéré, la commutation entre la première fréquence fc1 et la seconde fréquence fc2. La commutation entre la première fréquence fc1 et la seconde fréquence fc2 (et inversement) est exécutée selon la même périodicité de l'horloge d'échantillonnage du multiplexeur. Ainsi, la fréquence de coupure du module de commutation est égale à la valeur fc1 pendant au moins chaque partie transitoire du signal analogique, et égale à fc2 sur au moins une section de chaque palier du signal analogique.

Par ailleurs, le convertisseur analogique numérique convertit également le signal analogique en un signal numérique, selon une horloge de conversion synchrone avec l'horloge d'échantillonnage.

Ainsi, selon l'invention, il est proposé d'ajouter un module de commutation adapté pour commuter sa fréquence de coupure dans une chaine d'acquisition d'un signal analogique. Le module de commutation permet une réduction du bruit du signal analogique avant sa conversion en un signal numérique (la réduction du bruit d'un signal numérique est difficile à mettre en oeuvre dans certaines applications).

La Demanderesse a pu constater, dans le cadre de simulation numériques, une amélioration de 5 dB du rapport signal sur bruit d'un dispositif de conversion analogique/numérique comprenant un module de commutation selon l'invention.

L'invention concerne également un procédé d'atténuation du bruit d'un signal analogique avant sa conversion en un signal numérique, le procédé comprenant :

a. une étape de traitement d'au moins un signal analogique par une chaine d'acquisition, l'au moins un signal analogique présentant une forme d'onde impulsionnelle, la forme d'onde impulsionnelle comprenant, en séquence, une partie transitoire et un palier, la chaine d'acquisition se comportant comme un filtre passe-bas et présentant une fréquence de coupure,

b. une étape de transmission de l'au moins un signal analogique à un convertisseur analogique numérique par la chaine d'acquisition,

Le procédé exécute une commutation de la fréquence de coupure entre une première fréquence et une seconde fréquence inférieure à la première fréquence, de sorte que la fréquence de coupure de la chaine d'acquisition soit égale à la première fréquence pendant au moins toute l'étendue de la partie transitoire, et soit égale à la seconde fréquence sur l'étendue restante de la forme impulsionnelle, l'étendue restante étant non nulle.

De manière avantageuse, la chaine d'acquisition 10 peut comprendre une entrée connectée avec une sortie d'un capteur 60, ledit capteur 60 étant destiné à transmettre l'au moins un signal analogique correspondant à au moins une grandeur physique mesurée par le capteur 60, avantageusement le capteur 60 comprend au moins un des éléments choisis parmi : un capteur d'image CCD, un capteur d'image CMOS, un capteur de température, un capteur de pression, un capteur d'ondes sonores etc.

Toujours de manière avantageuse, la chaine d'acquisition 10 peut comprendre un contrôleur de commutation 70 adapté pour commander la commutation de la valeur de la fréquence de coupure du module de commutation 30 de fréquence de coupure entre la première fréquence fc1 et la seconde fréquence fc2.

La chaine d'acquisition 10, peut avantageusement être connectée à un convertisseur 40 analogique/numérique.

Le module de commutation 30 de fréquence de coupure peut être agencé de manière à ce que le convertisseur 40 analogique/numérique soit connecté à la chaine d'acquisition 10 via ledit module de commutation 30 de fréquence de coupure.

Le module de commutation 30 de fréquence de coupure peut comprendre un condensateur C dont une borne est connectée à la masse de la chaîne d'acquisition , et l'autre borne est connectée une sortie dudit module de commutation 30, le module de commutation 30 comprend également une première résistance électrique R1 et une seconde résistance électrique R2, les résistances électriques R1 et R2 étant connectées selon deux branches parallèles entre l'entrée et la sortie du module de commutation 30, le module de commutation 30 comprenant également un interrupteur I adapté pour ouvrir et fermer la branche comprenant la résistance électrique R1.

Le contrôleur de commutation 70 peut commander l'interrupteur I pour la commutation de la valeur de la fréquence de coupure du module de commutation 30 de fréquence de coupure entre la première fréquence fc1 et la seconde fréquence fc2.

L'interrupteur I peut être un transistor ou un commutateur électronique analogique.

Le module de traitement 20 peut comprendre une seconde sortie en opposition de phase avec la première, formant ainsi deux signaux appelés signaux différentiels, la seconde sortie étant connectée un second module de commutation 50 de fréquence de coupure présentant une fréquence de coupure fc, le module étant adapté pour commuter la valeur de sa fréquence de coupure fc entre une première fréquence fc1 et une seconde fréquence fc2, la première fréquence fc1 étant supérieure à la seconde fréquence fc2, le module de commutation 30 de fréquence et le second module de commutation 50 de fréquence étant adaptés pour transmettre chacun en leur sortie respective des signaux analogiques en opposition de phase.

## Revendications

1. Chaine d'acquisition (10) d'au moins un signal analogique, la chaine d'acquisition (10) comprenant :

   - un module de traitement (20) d'au moins un signal analogique présentant dans l'ordre une partie transitoire et un palier, l'au moins un signal analogique étant destinée à être transmis, par ledit module de traitement (20), à un convertisseur (40) analogique/numérique adapté pour transformer l'au moins un signal analogique en au moins un signal numérique ;
   - un module de commutation (30) de fréquence de coupure présentant une fréquence de coupure fc, le module étant adapté pour commuter la valeur de sa fréquence de coupure fc entre une première fréquence fc1 et une seconde fréquence fc2, la première fréquence fc1 étant supérieure à la seconde fréquence fc2, le module de commutation (30) de fréquence de coupure comprenant une entrée connectée à une sortie du module de traitement (20), la commutation de la fréquence de coupure fc de la première fréquence de coupure fc1 à la seconde fréquence de coupure intervenant dès lors que le palier du signal analogique est atteint,

   La chaine d'acquisition étant **caractérisée en ce que** le module de traitement (20) comprend en outre une seconde sortie en opposition de phase avec la première, formant ainsi deux signaux appelés signaux différentiels, la seconde sortie étant connectée un second module de commutation (50) de fréquence de coupure présentant une fréquence de coupure fc, le module étant adapté pour commuter la valeur de sa fréquence de coupure fc entre la première fréquence fc1 et la seconde fréquence fc2, le module de commutation (30) de fréquence et le second module de commutation (50) de fréquence étant adaptés pour transmettre chacun en leur sortie respective des signaux analogiques en opposition de phase, les signaux analogiques en sortie des modules de commutation (30) et (50) étant destinés à être traités par le convertisseur (40) pour résoudre le problème de génération des perturbations par la commutation de la fréquence de coupure.

2. Chaine d'acquisition (10) selon la revendication 1, dans laquelle la chaine d'acquisition (10) comprend une entrée connectée avec une sortie d'un capteur (60), ledit capteur (60) étant destiné à transmettre l'au moins un signal analogique correspondant à au moins une grandeur physique mesurée par le capteur (60), avantageusement le capteur (60) comprend au moins un des éléments choisis parmi : un capteur d'image CCD, un capteur d'image CMOS, une photodiode, un capteur de température, un capteur de pression, un capteur d'ondes sonores.

3. Chaine d'acquisition (10) selon la revendication 1 ou 2, dans laquelle la chaine d'acquisition (10) comprend un contrôleur de commutation (70) adapté pour commander la commutation de la valeur de la fréquence de coupure du module de commutation (30) de fréquence de coupure entre la première fréquence fc1 et la seconde fréquence fc2.

4. Chaine d'acquisition (10) selon l'une des revendications 1 à 3, dans laquelle la chaine d'acquisition (10) comprend un convertisseur (40) analogique/numérique.

5. Chaine d'acquisition (10) selon la revendication 4, dans laquelle le module de commutation (30) de fréquence de coupure est agencé de manière à ce que le convertisseur (40) analogique/numérique soit connecté au module de traitement (20) via ledit module de commutation (30) de fréquence de coupure.

6. Chaine d'acquisition (10) selon l'une des revendication 1 à 5, dans laquelle le module de commutation (30) de fréquence de coupure comprend un condensateur C dont une borne est connectée à une masse de la chaîne d'acquisition , et l'autre borne est connectée à une sortie dudit module de commutation (30), le module de commutation (30) comprend également une première résistance électrique R1 et une seconde résistance électrique R2, les résistances électriques R1 et R2 étant connectées selon deux branches parallèles entre l'entrée et la sortie du module de commutation (30), le module de commutation (30) comprenant également un interrupteur I adapté pour ouvrir et fermer la branche comprenant la résistance électrique R1.

7. Chaine d'acquisition (10) selon la revendication 6 en combinaison avec la revendication 3, dans laquelle le contrôleur de commutation (70) commande l'interrupteur I pour la commutation de la valeur de la fréquence de coupure du module de commutation (30) de fréquence de coupure entre la première fréquence fc1 et la seconde fréquence fc2.

8. Chaine d'acquisition (10) selon la revendication 6 ou 7, dans laquelle l'interrupteur I est un transistor ou un commutateur électronique analogique.

9. Chaine d'acquisition (10) selon l'une des revendications 1 à 8 en combinaison avec la revendication 5, dans laquelle le second module de commutation (50) de fréquence de coupure est agencé de manière à ce que le convertisseur (40) analogique/numérique soit connecté à la chaine d'acquisition (10) également via ledit second module de commutation (50) de fréquence de coupure.

**Patentansprüche**

1. Kette (10) zur Erfassung wenigstens eines analogen Signals, wobei die Erfassungskette (10) umfasst:

- ein Modul (20) zur Verarbeitung wenigstens eines analogen Signals, das einen Übergangsbereich und ein Plateau in dieser Reihenfolge aufweist, wobei das wenigstens eine analoge Signal dazu ausgelegt ist, durch das Verarbeitungsmodul (20) zu einem Analog-Digital-Wandler (40) übertragen zu werden, der dazu ausgelegt ist, das wenigstens eine analoge Signal in wenigstens ein digitales Signal zu transformieren;
- ein Abschneidefrequenzschaltmodul (30), das eine Abschneidefrequenz fc aufweist, wobei das Modul dazu ausgelegt ist, den Wert seiner Abschneidefrequenz fc zwischen einer ersten Frequenz fc1 und einer zweiten Frequenz fc2 zu schalten, wobei die erste Frequenz fc1 größer ist als die zweite Frequenz fc2, wobei das Abschneidefrequenzschaltmodul (30) einen Eingang umfasst, der mit einem Ausgang des Verarbeitungsmoduls (20) verbunden ist, wobei die Umschaltung der Abschneidefrequenz fc von der ersten Abschneidefrequenz fc1 zur zweiten Abschneidefrequenz erfolgt, sobald das Plateau des analogen Signals erreicht ist,

wobei die Erfassungskette **dadurch gekennzeichnet ist, dass** das Verarbeitungsmodul (20) ferner einen zweiten Ausgang mit entgegengesetzter Phase zum ersten umfasst, wodurch somit zwei Signale gebildet werden, genannt differentielle Signale, wobei der zweite Ausgang mit einem zweiten Abschneidefrequenzschaltmodul (50) verbunden ist, das eine Abschneidefrequenz fc aufweist, wobei das Modul dazu ausgelegt ist, den Wert seiner Abschneidefrequenz fc zwischen der ersten Frequenz fc1 und der zweiten Frequenz fc2 umzuschalten, wobei das Frequenzschaltmodul (30) und das zweite Frequenzschaltmodul (50) dazu ausgelegt sind, jeweils an ihrem jeweiligen Ausgang analoge Signale mit entgegengesetzter Phase zu übertragen, wobei die analogen Signale am Ausgang der Schaltmodule (30) und (50) dazu ausgelegt sind, durch den Wandler (40) verarbeitet zu werden, um das Problem der Erzeugung von Störungen durch die Umschaltung der Abschneidefrequenz zu lösen.

2. Erfassungskette (10) nach Anspruch 1, bei der die Erfassungskette (10) einen Eingang umfasst, der mit einem Ausgang eines Sensors (60) verbunden ist, wobei der Sensor (60) dazu ausgelegt ist, das wenigstens eine analoge Signal zu übertragen, das wenigstens einer durch den Sensor (60) gemessenen physikalischen Größe entspricht, wobei der Sensor (60) vorzugsweise eines der Elemente umfasst, ausgewählt aus den Folgenden: einen CCD-Bildsensor, einen CMOS-Bildsensor, eine Photodiode, einen Temperatursensor, einen Drucksensor, und einen Schallwellensensor.

3. Erfassungskette (10) nach Anspruch 1 oder 2, bei der die Erfassungskette (10) einen Schaltcontroller (70) umfasst, der dazu ausgelegt ist, die Umschaltung des Werts der Abschneidefrequenz des Abschneidefrequenzschaltmoduls (30) zwischen der ersten Frequenz fc1 und der zweite Frequenz fc2 zu steuern.

4. Erfassungskette (10) nach einem der Ansprüche 1 bis 3, bei der die Erfassungskette (10) einen Analog-Digital-Wandler (40) umfasst.

5. Erfassungskette (10) nach Anspruch 4, bei der das Abschneidefrequenzschaltmodul (30) derart ausgelegt ist, dass der Analog-Digital-Wandler (40) mit dem Verarbeitungsmodul (20) über das Abschneidefrequenzschaltmodul (30) verbunden ist.

6. Erfassungskette (10) nach einem der Ansprüche 1 bis 5, bei der das Abschneidefrequenzschaltmodul (30) einen Kondensator C umfasst, von dem ein Anschluss mit einer Masse der Erfassungskette verbunden ist, und der andere Anschluss mit einem Ausgang des Schaltmoduls (30) verbunden ist, wobei das Schaltmodul (30) ferner einen ersten elektrischen Widerstand R1 und einen zweiten elektrischen Widerstand R2 umfasst, wobei die elektrischen Widerstände R1 und R2 gemäß zwei parallelen Zweigen zwischen dem Eingang und dem Ausgang des Schaltmoduls (30) verbunden sind, wobei das Schaltmodul (30) ferner einen Unterbrecher I umfasst, der dazu ausgelegt ist, den Zweig zu öffnen und zu schließen, der den elektrischen Widerstand R1 umfasst.

7. Erfassungskette (10) nach Anspruch 6 in Kombination mit Anspruch 3, bei der der Schaltcontroller (70) den Unterbrecher I für das Umschalten des Werts der Abschneidefrequenz des Abschneidefrequenzschaltmoduls (30) zwischen der ersten Frequenz fc1 und der zweiten Frequenz fc2 steuert.

8. Erfassungskette (10) nach Anspruch 6 oder 7, bei der der Unterbrecher I ein Transistor oder ein analoger elektronischer Schalter ist.

9. Erfassungskette (10) nach einem der Ansprüche 1 bis 8 in Kombination mit Anspruch 5, bei der das zweite Abschneidefrequenzschaltmodul (50) derart ausgelegt ist, dass der Analog-Digital-Wandler (40) mit der Erfassungskette (10) auch über das zweite Abschneidefrequenzschaltmodul (50) verbunden ist.

**Claims**

1. Chain (10) for acquisition of at least one analogue signal, the acquisition chain (10) comprising:

   - a module (20) for processing at least one analogue signal having in order a transient part and a level stage, the at least one analogue signal being intended to be transmitted, by said processing module (20), to an analogue to digital converter (40) suitable for converting the at least one analogue signal into at least one digital signal;
   - a cutoff-frequency switching module (30) having a cutoff frequency fc, the module being suitable for switching the value of its cutoff frequency fc between a first frequency fc1 and a second frequency fc2, the first frequency fc1 being higher than the second frequency fc2, the cutoff-frequency switching module (30) comprising an input connected to an output of the processing module (20), the switching of the cutoff frequency fc from the first cutoff frequency fc1 to the second cutoff frequency occurring as soon as the level stage of the analogue signal is reached,

   the acquisition chain being **characterised in that** the processing module (20) further comprises a second output in phase opposition to the first, thus forming two signals referred to as differential signals, the second output being connected to a second cutoff-frequency switching module (50) having a cutoff frequency fc, the module being suitable for switching the value of its cutoff frequency fc between the first frequency fc1 and the second frequency fc2, the frequency switching module (30) and the second frequency switching module (50) being suitable each for transmitting at their respective output analogue signals in phase opposition, the analogue signals at the output of the switching modules (30) and (50) being intended to be processed by the converter (40) in order to solve the problem of the generation of interference by the cutoff-frequency switching.

2. Acquisition chain (10) according to claim 1, wherein the acquisition chain (10) comprises an input connected with an output of a sensor (60), said sensor (60) being intended to transmit the at least one analogue signal corresponding to at least one physical quantity measured by the sensor (60), advantageously the sensor (60) comprises at least one of the elements chosen from: a CCD image sensor, a CMOS image sensor, a photodiode, a temperature sensor, a pressure sensor or a soundwave sensor.

3. Acquisition chain (10) according to claim 1 or claim 2, wherein the acquisition chain (10) comprises a switching controller (70) suitable for controlling the switching of the value of the cutoff frequency of the cutoff-frequency switching module (30) between the first frequency fc1 and the second frequency fc2.

4. Acquisition chain (10) according to any of claims 1 to 3, wherein the acquisition chain (10) comprises an analogue to digital converter (40).

5. Acquisition chain (10) according to claim 4, wherein the cutoff-frequency switching module (30) is arranged so that the analogue to digital converter (40) is connected to the processing module (20) via said cutoff-frequency switching module (30).

6. Acquisition chain (10) according to any of claims 1 to 5, wherein the cutoff-frequency switching module (30) comprises a capacitor C, one terminal of which is connected to a ground of the acquisition chain and the other terminal of which is connected to an output of said switching module (30), the switching module (30) also comprises a first electrical resistor R1 and a second electrical resistor R2, the electrical resistors R1 and R2 being connected in two parallel arms between the input and output of the switching module (30), the switching module (30) also comprising a switch I suitable for opening and closing the arm comprising the electrical resistor R1.

7. Acquisition chain (10) according to claim 6 in combination with claim 3, wherein the switching controller (70) controls the switch I for switching the value of the cutoff frequency of the cutoff-frequency switching module (30) between the first frequency fc1 and the second frequency fc2.

8. Acquisition chain (10) according to claim 6 or claim 7, wherein the switch I is a transistor or an analogue electronic switch.

9. Acquisition chain (10) according to any of claims 1 to 8 in combination with claim 5, wherein the second cutoff-frequency switching module (50) is arranged so that the analogue to digital converter (40) is connected to the acquisition chain (10) also via said second cutoff-frequency switching module (50).

FIG.1
Art antérieur

FIG.2

FIG.3

FIG.4

FIG.5

FIG.6

**EP 3 258 682 B1**

## RÉFÉRENCES CITÉES DANS LA DESCRIPTION

**Documents brevets cités dans la description**

- US 6111606 A

- JP 2006060512 B